(19) **Europäisches Patentamt / European Patent Office / Office européen des brevets**

(11) **EP 2 301 015 B1**

(12) **EUROPEAN PATENT SPECIFICATION**

(45) Date of publication and mention
of the grant of the patent:
**04.09.2019 Bulletin 2019/36**

(21) Application number: **09761845.8**

(22) Date of filing: **15.05.2009**

(51) Int Cl.:
***G10L 19/005*** (2013.01)

(86) International application number:
**PCT/FI2009/050403**

(87) International publication number:
**WO 2009/150290 (17.12.2009 Gazette 2009/51)**

(54) **METHOD AND APPARATUS FOR ERROR CONCEALMENT OF ENCODED AUDIO DATA**

VERFAHREN UND VORRICHTUNG ZUR FEHLERVERBERGUNG CODIERTER AUDIODATEN

PROCÉDÉ ET APPAREIL DE MASQUAGE D'ERREUR DE DONNÉES AUDIO CODÉES

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **13.06.2008 US 61572 P**

(43) Date of publication of application:
**30.03.2011 Bulletin 2011/13**

(73) Proprietor: **Nokia Technologies Oy
02610 Espoo (FI)**

(72) Inventors:
• **LAAKSONEN, Lasse**
**37120 Nokia (FI)**
• **TAMMI, Mikko**
**33310 Tampere (FI)**
• **VASILACHE, Adriana**
**33580 Tampere (FI)**
• **RÄMÖ, Anssi**
**33720 Tampere (FI)**

(74) Representative: **Nokia EPO representatives
Nokia Technologies Oy
Karaportti 3
02610 Espoo (FI)**

(56) References cited:
**WO-A1-2008/062959      WO-A1-2008/062959
WO-A2-2004/059894      WO-A2-2004/059894**

• **PARIKH V N ET AL: "Frame erasure concealment
using sinusoidal analysis synthesis and its
application to MDCT-based codecs",
ACOUSTICS, SPEECH, AND SIGNAL
PROCESSING, 2000. ICASSP '00. PROCEEDING
S. 2000 IEEE INTERNATIONAL CONFERENCE ON
5-9 JUNE 2000, PISCATAWAY, NJ, USA, IEEE, vol.
2, 5 June 2000 (2000-06-05), pages 905-908,
XP010504870, ISBN: 978-0-7803-6293-2**
• **PARIKH, VN ET AL.: 'Frame Erasure Concealment
Using Sinusoidal Analysis-Synthesis and Its
Application to MDCT-Based Codecs'
PROCEEDINGS OF THE IEEE INTERNATIONAL
CONFERENCE ON ACOUSTICS, SPEECH, AND
SIGNAL PROCESSING 05 June 2000 - 09 June
2000, XP010504870**

**Description**

**FIELD OF INVENTION**

This invention relates to encoding and decoding of audio data. In particular, the present invention relates to the concealment of errors in encoded audio data.

**BACKGROUND OF THE INVENTION**

This section is intended to provide a background or context to the invention that is recited in the claims. The description herein may include concepts that could be pursued, but are not necessarily ones that have been previously conceived or pursued. Therefore, unless otherwise indicated herein, what is described in this section is not prior art to the description and claims in this application and is not admitted to be prior art by inclusion in this section.

Embedded variable rate coding, also referred to as layered coding, generally refers to a speech coding algorithm which produces a bit stream such that a subset of the bit stream can be decoded with good quality. Typically, a core codec operates at a low bit rate and a number of layers are used on top of the core to improve the output quality (including, for example, possibly extending the frequency bandwidth or improving the granularity of the coding). At the decoder, just the part of the bit stream corresponding to the core codec, or additionally parts of or the entire bit stream corresponding to one or more of the layers on top of the core, can be decoded to produce the output signal.

The International Telecommunication Union Telecommunication Standardization Sector (ITU-T) is in the process of developing super-wideband (SWB) and stereo extensions to G.718 (known as EV-VBR) and G.729.1 embedded variable rate speech codecs. The SWB extension, which extends the frequency bandwidth of the EV-VBR codec from 7 kHz to 14 kHz, and the stereo extension to be standardized bridge the gap between speech and audio coding. The G.718 and G.729.1 are examples of core codecs on top of which an extension can be applied.

Channel errors occur in wireless communications networks and packet networks. These errors may cause some of the data segments arriving at the receiver to be corrupted (e.g., contaminated by bit errors), and some of the data segments may be completely lost or erased. For example, in the case of G.718 and G.729.1 codecs, channel errors result in a need to deal with frame erasures. There is a need to provide channel error robustness in the SWB (and stereo) extension, particularly from the G.718 point of view.

Patent application WO2004/059894 discloses an error concealment method for recovering lost data in an AAC bitstream in the compressed domain. The bitstream is partitioned into frames each having a plurality of data parts including quantized MDCT coefficients. The data parts are stored in order in the event of a lost frame, the corresponding data part in the neighbouring frames is used to conceal the errors in the current frame.

IEEE publication entitled Frame Erasure Concealment Using Sinusoidal Analysis-Synthesis and its Applications to MDCT-Based Codec discloses a frame erasure concealment algorithm based on sinusoidal analysis-synthesis and its application to MDCT-based codecs. In particular it is discloses that when a frame is lost, sinusoidal analysis of the previous decoded signal is performed to give a set of sinusoids to be used in the synthesis of the waveform for the lost frame.

Patent application WO2008/062959 also discloses a method of error concealment in the event of a lost frame for audio decoding. It is disclosed that the error concealment is selected to take place in either the time domain or frequency domain according to a predetermined criteria. The frequency domain error concealment method can be one of either an interpolation of the MDCT coefficients between previous good frame and a following good frame, or a method of repetition of the MDCT coefficients from a previous good frame.

**SUMMARY OF THE INVENTION**

In one aspect of the invention, a method of frame error concealment in encoded audio data using extension coding where lower frequency content is mapped to higher frequencies, comprises receiving encoded audio data in a plurality of frames; reconstructing at least one parameter for a frame with frame error based on at least one saved parameter value from at least one other frame of the plurality of frames, wherein reconstructing at least one parameter comprises: deriving modified discrete cosine transform spectrum values, m, for a higher frequency range in accordance with *for*

$$k = 0; k < L_{highspectrum}; k++$$
$$m\left(k + L_{lowspectrum}\right) = m_{prev}\left(k\right) * fac_{spect}$$

wherein $m_{prev}$ denotes at least one saved higher layer modified discrete cosine transform spectrum value, $L_{highspectrum}$ denotes the number of modified discrete cosine transform spectrum values over the higher spectrum, $L_{lowspectrum}$ denotes the number of modified discrete cosine transform spectrum values over the low spectrum and $fac_{spect}$ denotes respective scaling factor; deriving values for a subset of the modified discrete cosine transform spectrum values for the higher frequency range in accordance with *for*

$$k = 0; k < N_{\sin}; k++$$
$$m\left(pos_{\sin}(k) + L_{lowspectrum}\right) = m_{prev}\left(pos_{\sin}(k)\right) * fac_{\sin}$$

wherein $m_{prev}$ denotes said at least one saved higher layer modified discrete cosine transform spectrum, $fac_{sin}$ denotes respective scaling factor and $pos_{sin}$ is a variable descriptive of the positions within $m$ and $m_{prev}$, wherein if a preceding valid frame to the frame with frame error is a generic frame, the $fac_{spect}$ scaling factor is smaller than the $fac_{sin}$ scaling factor, wherein if the preceding valid frame to the frame with frame error is a tonal frame the $fac_{sin}$ scaling factor is only used and wherein the variable descriptive of the positions within $m$, $pos_{sin}$, are from the preceding valid frame; and applying the derived values to the frame with frame error.

In one embodiment, the saved parameter values correspond to parameter values of one or more previous frames without errors. In one embodiment, the saved parameter values correspond to parameter values of the most recent previous frame without errors. In one embodiment the saved parameter values correspond to at least one parameter value of at least one future frame. In one embodiment, the saved parameter values correspond to parameter values of a previous reconstructed frame with errors.

In another aspect of the invention, an apparatus for frame error concealment in encoded audio data using extension coding where lower frequency content is mapped to higher frequencies comprises a decoder configured to receive encoded audio data in a plurality of frames; and reconstruct at least one parameter for a frame with frame error based on at least one saved parameter value from at least one other frame of the plurality of frames, wherein reconstructing at least one parameter comprises: deriving modified discrete cosine transform spectrum values, m, for a higher frequency range in accordance with *for*

$$k = 0; k < L_{highspectrum}; k++$$
$$m\left(k + L_{lowspectrum}\right) = m_{prev}(k) * fac_{spect}$$

wherein $m_{prev}$ denotes at least one saved higher layer modified discrete cosine transform spectrum value, $L_{highspectrum}$ denotes the number of modified discrete cosine transform spectrum values over the higher spectrum, $L_{lowspectrum}$ denotes the number of modified discrete cosine transform spectrum values over the low spectrum and $fac_{spect}$ denotes respective scaling factor; deriving values a subset of the modified discrete cosine transform spectrum values for the higher frequency range in accordance with *for*

$$k = 0; k < N_{\sin}; k++$$
$$m\left(pos_{\sin}(k) + L_{lowspectrum}\right) = m_{prev}\left(pos_{\sin}(k)\right) * fac_{\sin},$$

wherein $m_{prev}$ denotes said at least one saved higher layer modified discrete cosine transform spectrum, $fac_{sin}$ denotes respective scaling factor and $pos_{sin}$ is a variable descriptive of the positions within $m$ and $m_{prev}$, wherein if a preceding valid frame to the frame with frame error is a generic frame, the $fac_{spect}$ scaling factor is smaller than the $fac_{sin}$ scaling factor, wherein if the preceding valid frame to the frame with frame error is a tonal frame the $fac_{sin}$ scaling factor is only used and wherein the variable descriptive of the positions within $m$, $pos_{sin}$, are from the preceding valid frame; and applying the scaled values to the frame with frame error.

In one embodiment, the saved parameter values correspond to parameter values of one or more previous frames without errors. In one embodiment, the saved parameter values correspond to parameter values of the most recent previous frame without errors. In one embodiment, the saved parameter values correspond to parameter values of a previous reconstructed frame with errors. In one embodiment the saved parameter values correspond to at least one parameter value of at least one future frame.

In another aspect, a computer program product for frame error concealment in encoded audio data using extension coding where lower frequency content is mapped to higher frequencies, use with a computer, the computer program code comprising: code causing the apparatus to receive encoded audio data in a plurality of frames; and code for reconstructing at least one parameter for a frame with frame error based on at least one saved parameter value from at least one other frame of the plurality of frames, wherein the code for reconstructing at least one parameter comprises: code for deriving modified discrete cosine transform spectrum values, m, for a higher frequency range in accordance with *for*

$$k = 0; k < L_{highspectrum}; k++$$
$$m(k + L_{lowspectrum}) = m_{prev}(k) * fac_{spect},$$

wherein $m_{prev}$ denotes at least one saved higher layer modified discrete cosine transform spectrum value, $L_{highspectrum}$ denotes the number of modified discrete cosine transform spectrum values over the higher spectrum, $L_{lowspectrum}$ denotes the number of modified discrete cosine transform spectrum values over the low spectrum and $fac_{spect}$ denotes respective scaling factor; code for deriving values for a subset of the modified discrete cosine transform spectrum values for the higher frequency range in accordance with *for*

$$k = 0; k < N_{sin}; k++$$
$$m(pos_{sin}(k) + L_{lowspectrum}) = m_{prev}(pos_{sin}(k)) * fac_{sin}$$

wherein $m_{prev}$ denotes said at least one saved higher layer modified discrete cosine transform spectrum, $fac_{sin}$ denotes respective scaling factor and $pos_{sin}$ is a variable descriptive of the positions within $m$ and $m_{prev}$, wherein if a preceding valid frame to the frame with frame error is a generic frame, the $fac_{spect}$ scaling factor is smaller than the $fac_{sin}$ scaling factor, wherein if the preceding valid frame to the frame with frame error is a tonal frame the $fac_{sin}$ scaling factor is only used and wherein the variable descriptive of the positions within $m$, $pos_{sin}$, are from the preceding valid frame; and applying the scaled values to the frame with frame error.

These and other advantages and features of various embodiments of the present invention, together with the organization and manner of operation thereof, will become apparent from the following detailed description when taken in conjunction with the accompanying drawings.

**BRIEF DESCRIPTION OF THE DRAWINGS**

Example embodiments of the invention are described by referring to the attached drawings, in which:

Figure 1 is a flowchart illustrating an example frame error concealment method in accordance with an embodiment of the present invention;
Figures 2A and 2B illustrate the application of frame error concealment method in accordance with an embodiment of the present invention to a generic frame;
Figures 3A and 3B illustrate the application of frame error concealment method in accordance with an embodiment of the present invention to a tonal frame;
Figure 4 is an overview diagram of a system within which various embodiments of the present invention may be implemented;
Figure 5 illustrates a perspective view of an example electronic device which may be utilized in accordance with the various embodiments of the present invention;
Figure 6 is a schematic representation of the circuitry which may be included in the electronic device of Fig. 5; and
Figure 7 is a graphical representation of a generic multimedia communication system within which various embodiments may be implemented.

**DETAILED DESCRIPTION OF THE VARIOUS EMBODIMENTS**

In the following description, for purposes of explanation and not limitation, details and descriptions are set forth in order to provide a thorough understanding of the present invention. However, it will be apparent to those skilled in the art that the present invention may be practiced in other embodiments that depart from these details and descriptions.

Frame erasures can distort the core codec output. While the perceptual effects of frame erasures have been minimized by existing mechanisms used in the codecs, such as G.718, the signal shape in both time and frequency domains may be considerably affected, particularly in extensive number of frame losses. One example of the approach used for extension coding is to map the lower frequency content to the higher frequencies. In such an approach frame erasures on the lower frequency content may also affect signal quality on the higher frequencies. This may lead to audible and disturbing distortions in the reconstructed output signal.

An example embodiment of the extension coding framework for a core codec, such as the G.718 and G.729.1 codecs mentioned above, may utilize two modes. One mode may be a tonal coding mode, optimized for processing tonal signals exhibiting a periodic higher frequency range. The second mode may be a generic coding mode that handles other types of frames. The extension coding may operate for example in the modified discrete cosine transform (MDCT) domain. In other embodiments, other transforms, such as Fast Fourier Transform (FFT), may be used. In the tonal coding mode, sinusoids that approximate the perceptually most relevant signal components are inserted to the transform domain spectrum (e.g., the MDCT spectrum). In generic coding mode, the higher frequency range is divided into one or more frequency bands, and the low frequency area that best resembles the higher frequency content in each frequency band is mapped to the higher frequencies utilizing a set of gain factors (e.g., two separate gain factors). This one variation of the technique is generally referred to as a "bandwidth extension."

Embodiments of the present invention utilize extension coding parameters of the example framework described above (i.e., a framework) employing generic and tonal coding modes, for frame error concealment in order to minimize the number of disturbing artifacts and to maintain the perceptual signal characteristics of the extension part during frame errors.

In one embodiment, the error concealment is implemented as part of an extension coding framework including a frame-based classification, a generic coding mode (e.g. a bandwidth extension mode) where the upper frequency range is constructed by mapping the lower frequencies to the higher frequencies, and a tonal coding mode where the frame is encoded by inserting a number of sinusoid components. In another embodiment, the error concealment is implemented as part of an extension coding framework that employs a combination of these methods (i.e. a combination of mechanisms used in the generic coding mode and the tonal coding mode) for all frames without a classification step. In yet another embodiment, additional coding modes to the generic mode and the tonal mode may be employed.

Extension coding employed in conjunction with a certain core coding, for example with G.718 core codec, provides various parameters which may be utilized for the frame error concealment. Available parameters in the extension coding framework may comprise: core codec coding mode, extension coding mode, generic coding mode parameters (e.g., lag indices for bands, signs, a set of gains for the frequency band mapping, time-domain energy adjustment parameters, and similar parameters as used for the tonal mode), and tonal mode parameters (sinusoid positions, signs, and amplitudes). In addition, the processed signal may consist either of single channel or of multiple channels (e.g., stereo or binaural signal).

Embodiments of the present invention allow the higher frequencies to be maintained perceptually similar as in the preceding frame for individual frame errors, while ramping the energy down for longer error bursts. Thus, embodiments of the present invention may also be used in switching from a signal including the extension contribution (e.g. a SWB signal) to a signal consisting of core codec output only (e.g. WB signal), which may happen, for example, in an embedded scalable coding or transmission when the bitstream is truncated prior to decoding.

Since the tonal mode is generally used for parts of the signal that have a periodic nature in the higher frequencies, certain embodiments of the present invention use the assumption that these qualities should be preserved in the signal also during frame errors, rather than producing a point of discontinuity. While abruptly changing the energy levels in some frames may create perceptually annoying effects, the aim in generic frames may be to attenuate the erroneous output. In accordance with certain embodiments of the present invention, the ramping down of the energy is done rather slowly, thus maintaining the perceptual characteristics of the previous frame or frames for single frame errors. In this regard, embodiments of the present invention may be useful in switching from extension codec output to core codec only output (e.g., from SWB to WB, when the SWB layers are truncated). Due to the overlap-add nature of the MDCT, the contribution from the previous (valid) frame influences the first erased frame (or the frame immediately after a bitstream truncation), and the difference between a slow ramp down of energy and inserting a frame consisting of samples with zero value may not necessarily be pronounced for some signals.

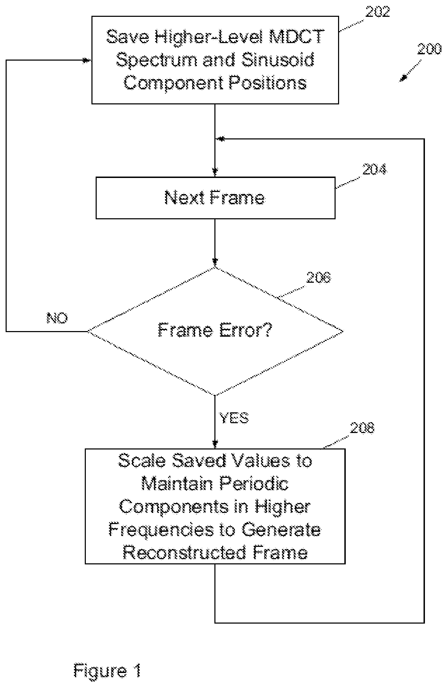

Reference is now made to Figure 1 which illustrates an example process 200 for frame error concealment in accordance with an embodiment of the present invention. To implement various embodiments of the present invention, the higher layer MDCT spectrum and information about the sinusoid components, for example positions, signs and amplitudes, from one or more previous frames may be kept in memory to be used in the next frame should there be a frame error (block 202). At block 204, the process proceeds to the next frame and determines whether a frame error exists (block 206). If no error exists, the process returns to block 202 and saves the above-noted parameters. During a frame error, the MDCT spectrum of the one or more previous frames is thus available and can be processed, for example scaled down, and passed along as the high frequency contribution for the current frame. In addition, the information regarding the sinusoidal components, for example positions, signs and amplitudes, in the MDCT spectrum are also known. Accordingly, a reconstructed frame can be generated (block 208).

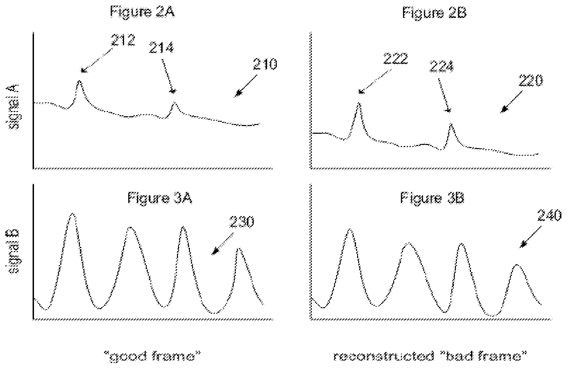

Figures 2A, 2B, 3A and 3B illustrate example implementations of the frame error concealment in accordance with embodiments of the present invention. Figures 2A and 2B illustrate the effect of the application of a frame error concealment to a generic frame. In this regard, Figure 2A illustrates a spectrum of a valid frame 210 with no frame error. As noted above, the higher layer MDCT spectrum and the sinusoid component information from one or more previous valid frames 210 may be saved. Figure 2B illustrates an example of a spectrum of a reconstructed frame 220 replacing a missing frame after the application of the frame error concealment in accordance with embodiments of the present invention. As may be noted from Figures 2A and 2B, the energy of the content derived from the previous frame(s) (Figure 2A) is attenuated more strongly, while a weaker attenuation is applied at the sinusoid components 212, 214, 222, 224.

Figures 3A and 3B illustrate the application of a frame error concealment to a tonal frame. In this regard, Figure 3A illustrates a valid frame 230 with no frame error, and Figure 3B illustrates a reconstructed frame 240 used to replace a missing frame after the application of the frame error concealment in accordance with embodiments of the present invention. For a tonal frame 230, 240, an even weaker attenuation is applied than for the sinusoid components 212, 214, 222, 224 of the generic signal of Figures 2A and 2B.

Thus, in accordance with embodiments of the present invention, the processing of the MDCT spectrum can be described as follows. A first scaling is performed for the entire higher frequency range: *for*

$$k = 0; k < L_{highspectrum}; k++$$
$$m\big(k + L_{lowspectrum}\big) = m_{prev}(k) * fac_{spect}.$$

A second scaling is applied for the sinusoidal components as given by: *for*

$$k = 0; k < N_{\sin}; k++$$
$$m\big(pos_{\sin}(k) + L_{lowspectrum}\big) = m_{prev}\big(pos_{\sin}(k)\big) * fac_{\sin}.$$

In other embodiments, instead of applying a constant scaling factor to all frequency components, it is also possible to use a scaling function that, for example, attenuates the higher part of the high frequency range more than the lower part.

In accordance with embodiments of the present invention, the scaling factor values may be decided based on information such as the types of the preceding frames used for error concealment processing. In one embodiment, only the extension coding mode - e.g. the SWB mode - of the preceding valid frame is considered. If it is a generic frame, scaling factors of, for example, 0.5 and 0.6 are used. For a tonal frame, a scaling factor of 0.9 for the amplitudes of the sinusoidal components may be used. Thus, in this embodiment, there is no other content in the MDCT spectrum in tonal frames except for the sinusoid components, and the process to obtain the MDCT spectrum for the current frame, *m(k),* therefore, could be considerably simplified. In other embodiments, there may be content other than the sinusoids in what may be considered the tonal mode.

Note that, in certain embodiments, data from more than one of the previous frames may be considered. Further, some embodiments may use, for example, data from a single previous frame other than the most recent frame. In yet another embodiment, data from one or more future frames can be considered.

After the MDCT spectrum for the missing frame is constructed, it may be processed in a similar manner to a valid frame. Thus, an inverse transform may be applied to obtain the time-domain signal. In certain embodiments, the MDCT spectrum from the missing frame may also be saved to be used in the next frame in case that frame would also be missing and error concealment processing needs to be invoked.

In certain embodiments of the present invention, further scaling, now in the time-domain, may be applied to the signal. In the framework used here as an example, which can be used for example in conjunction with the G.718 or G.729.1 codecs, downscaling of the signal may be performed in the time domain, for example on a subframe-by-subframe basis over 8 subframes in each frame, provided this is seen necessary at the encoder side. In accordance with embodiments of the present invention, in order to avoid introducing unnecessarily strong energy content in the higher frequencies, two examples of measures that may be utilized to avoid this are presented next.

First, in case the preceding valid frame is a generic coding, a subframe-by-subframe downscaling may be carried out. It can utilize, e.g., the scaling values of the preceding valid frame or a specific scaling scheme designed for frame erasures. The latter may be, e.g., a simple ramp down of the current frame high-frequency energy.

Second, the contribution in the higher frequency band may be ramped down utilizing a smooth window over one or more missing (reconstructed) frames. In various embodiments, this action may be performed in addition to the previous time-domain scalings or instead of them.

The decision logic for the scaling scheme may be more complex or less complex in different embodiments of the present invention. In particular, in some embodiments the core codec coding mode may be considered along with the extension coding mode. In some embodiments some of the parameters of the core codec may be considered. In one embodiment, the tonal mode flag is switched to zero after the first missing frame to attenuate the sinusoidal components quicker in case the frame erasure state is longer than one frame.

Thus, embodiments of the present invention provide improved performance during frame erasures without introducing any annoying artifacts.

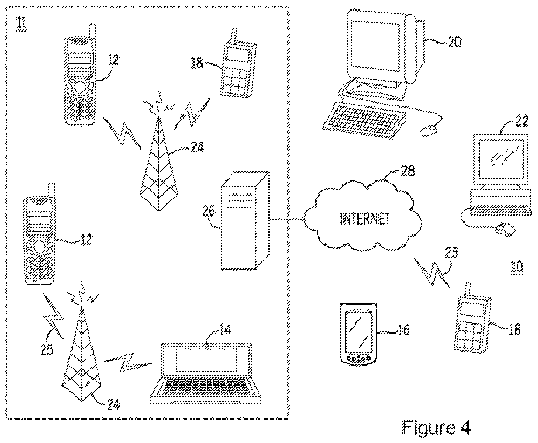

Figure 4 shows a system 10 in which various embodiments of the present invention can be utilized, comprising multiple communication devices that can communicate through one or more networks. The system 10 may comprise any combination of wired or wireless networks including, but not limited to, a mobile telephone network, a wireless Local Area Network (LAN), a Bluetooth personal area network, an Ethernet LAN, a token ring LAN, a wide area network, the Internet, etc. The system 10 may include both wired and wireless communication devices.

For exemplification, the system 10 shown in Figure 4 includes a mobile telephone network 11 and the Internet 28. Connectivity to the Internet 28 may include, but is not limited to, long range wireless connections, short range wireless connections, and various wired connections including, but not limited to, telephone lines, cable lines, power lines, and the like.

The example communication devices of the system 10 may include, but are not limited to, an electronic device 12 in the form of a mobile telephone, a combination personal digital assistant (PDA) and mobile telephone 14, a PDA 16, an integrated messaging device (IMD) 18, a desktop computer 20, a notebook computer 22, etc. The communication devices may be stationary or mobile as when carried by an individual who is moving. The communication devices may also be located in a mode of transportation including, but not limited to, an automobile, a truck, a taxi, a bus, a train, a boat, an airplane, a bicycle, a motorcycle, etc. Some or all of the communication devices may send and receive calls and messages and communicate with service providers through a wireless connection 25 to a base station 24. The base station 24 may be connected to a network server 26 that allows communication between the mobile telephone network 11 and the Internet 28. The system 10 may include additional communication devices and communication devices of different types.

The communication devices may communicate using various transmission technologies including, but not limited to, Code Division Multiple Access (CDMA), Global System for Mobile Communications (GSM), Universal Mobile Telecommunications System (UMTS), Time Division Multiple Access (TDMA), Frequency Division Multiple Access (FDMA), Transmission Control Protocol/Internet Protocol (TCP/IP), Short Messaging Service (SMS), Multimedia Messaging Service (MMS), e-mail, Instant Messaging Service (IMS), Bluetooth, IEEE 802.11, etc. A communication device involved in implementing various embodiments of the present invention may communicate using various media including, but not limited to, radio, infrared, laser, cable connection, and the like.

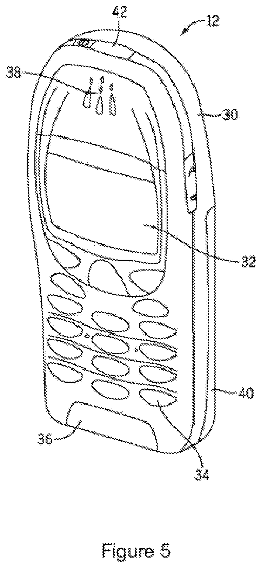

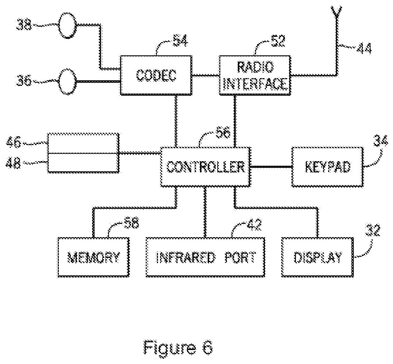

Figures 5 and 6 show one representative electronic device 28 which may be used as a network node in accordance to the various embodiments of the present invention. It should be understood, however, that the scope of the present invention is not intended to be limited to one particular type of device. The electronic device 28 of Figures 5 and 6 includes a housing 30, a display 32 in the form of a liquid crystal display, a keypad 34, a microphone 36, an earpiece 38, a battery 40, an infrared port 42, an antenna 44, a smart card 46 in the form of a UICC according to one embodiment, a card reader 48, radio interface circuitry 52, codec circuitry 54, a controller 56 and a memory 58. The above described components enable the electronic device 28 to send/receive various messages to/from other devices that may reside on a network in accordance with the various embodiments of the present invention. Individual circuits and elements are all of a type well known in the art, for example in the Nokia range of mobile telephones.

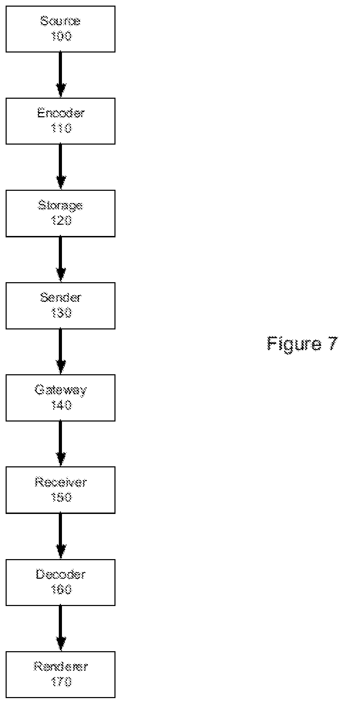

Figure 7 is a graphical representation of a generic multimedia communication system within which various embodiments may be implemented. As shown in Figure 7, a data source 100 provides a source signal in an analog, uncompressed digital, or compressed digital format, or any combination of these formats. An encoder 110 encodes the source signal into a coded media bitstream. It should be noted that a bitstream to be decoded can be received directly or indirectly from a remote device located within virtually any type of network. Additionally, the bitstream can be received from local hardware or software. The encoder 110 may be capable of encoding more than one media type, such as audio and video, or more than one encoder 110 may be required to code different media types of the source signal. The encoder 110 may also get synthetically produced input, such as graphics and text, or it may be capable of producing coded bitstreams of synthetic media. In the following, only processing of one coded media bitstream of one media type is considered to simplify the description. It should be noted, however, that typically real-time broadcast services comprise several streams (typically at least one audio, video and text sub-titling stream). It should also be noted that the system may include many encoders, but in Figure 7 only one encoder 110 is represented to simplify the description without a lack of generality. It should be further understood that, although text and examples contained herein may specifically describe an encoding process, one skilled in the art would understand that the same concepts and principles also apply to the corresponding decoding process and vice versa.

The coded media bitstream is transferred to a storage 120. The storage 120 may comprise any type of mass memory to store the coded media bitstream. The format of the coded media bitstream in the storage 120 may be an elementary self-contained bitstream format, or one or more coded media bitstreams may be encapsulated into a container file. Some systems operate "live", i.e. omit storage and transfer coded media bitstream from the encoder 110 directly to the sender 130. The coded media bitstream is then transferred to the sender 130, also referred to as the server, on a need basis. The format used in the transmission may be an elementary self-contained bitstream format, a packet stream format, or one or more coded media bitstreams may be encapsulated into a container file. The encoder 110, the storage 120, and the server 130 may reside in the same physical device or they may be included in separate devices. The encoder 110 and server 130 may operate with live real-time content, in which case the coded media bitstream is typically not stored permanently, but rather buffered for small periods of time in the content encoder 110 and/or in the server 130 to smooth out variations in processing delay, transfer delay, and coded media bitrate.

The server 130 sends the coded media bitstream using a communication protocol stack. The stack may include but is not limited to Real-Time Transport Protocol (RTP), User Datagram Protocol (UDP), and Internet Protocol (IP). When the communication protocol stack is packet-oriented, the server 130 encapsulates the coded media bitstream into packets. For example, when RTP is used, the server 130 encapsulates the coded media bitstream into RTP packets according to an RTP payload format. Typically, each media type has a dedicated RTP payload format. It should be again noted that a system may contain more than one server 130, but for the sake of simplicity, the following description only considers one server 130.

The server 130 may or may not be connected to a gateway 140 through a communication network. The gateway 140 may perform different types of functions, such as translation of a packet stream according to one communication protocol stack to another communication protocol stack, merging and forking of data streams, and manipulation of data stream according to the downlink and/or receiver capabilities, such as controlling the bit rate of the forwarded stream according to prevailing downlink network conditions. Examples of gateways 140 include MCUs, gateways between circuit-switched and packet-switched video telephony, Push-to-talk over Cellular (PoC) servers, IP encapsulators in digital video broadcasting-handheld (DVB-H) systems, or set-top boxes that forward broadcast transmissions locally to home wireless networks. When RTP is used, the gateway 140 is called an RTP mixer or an RTP translator and typically acts as an endpoint of an RTP connection.

The system includes one or more receivers 150, typically capable of receiving, demodulating, and de-capsulating the transmitted signal into a coded media bitstream. The coded media bitstream is transferred to a recording storage 155. The recording storage 155 may comprise any type of mass memory to store the coded media bitstream. The recording storage 155 may alternatively or additionally comprise computation memory, such as random access memory. The format of the coded media bitstream in the recording storage 155 may be an elementary self-contained bitstream format, or one or more coded media bitstreams may be encapsulated into a container file. If there are multiple coded media bitstreams, such as an audio stream and a video stream, associated with each other, a container file is typically used and the receiver 150 comprises or is attached to a container file generator producing a container file from input streams. Some systems operate "live," i.e. omit the recording storage 155 and transfer coded media bitstream from the receiver 150 directly to the decoder 160. In some systems, only the most recent part of the recorded stream, e.g., the most recent 10-minute excerption of the recorded stream, is maintained in the recording storage 155, while any earlier recorded data is discarded from the recording storage 155.

The coded media bitstream is transferred from the recording storage 155 to the decoder 160. If there are many coded media bitstreams, such as an audio stream and a video stream, associated with each other and encapsulated into a container file, a file parser (not shown in the figure) is used to decapsulate each coded media bitstream from the container file. The recording storage 155 or a decoder 160 may comprise the file parser, or the file parser is attached to either recording storage 155 or the decoder 160.

The coded media bitstream is typically processed further by a decoder 160, whose output is one or more uncompressed media streams. Finally, a renderer 170 may reproduce the uncompressed media streams with a loudspeaker or a display, for example. The receiver 150, recording storage 155, decoder 160, and renderer 170 may reside in the same physical device or they may be included in separate devices.

A sender 130 according to various embodiments may be configured to select the transmitted layers for multiple reasons, such as to respond to requests of the receiver 150 or prevailing conditions of the network over which the bitstream is conveyed. A request from the receiver can be, e.g., a request for a change of layers for display or a change of a rendering device having different capabilities compared to the previous one.

Various embodiments described herein are described in the general context of method steps or processes, which may be implemented in one embodiment by a computer program product, embodied in a computer-readable medium, including computer-executable instructions, such as program code, executed by computers in networked environments. A computer-readable medium may include removable and non-removable storage devices including, but not limited to, Read Only Memory (ROM), Random Access Memory (RAM), compact discs (CDs), digital versatile discs (DVD), etc. Generally, program modules may include routines, programs, objects, components, data structures, etc.

that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes.

Embodiments of the present invention may be implemented in software, hardware, application logic or a combination of software, hardware and application logic. The software, application logic and/or hardware may reside, for example, on a chipset, a mobile device, a desktop, a laptop or a server. Software and web implementations of various embodiments can be accomplished with standard programming techniques with rule-based logic and other logic to accomplish various database searching steps or processes, correlation steps or processes, comparison steps or processes and decision steps or processes. Various embodiments may also be fully or partially implemented within network elements or modules. It should be noted that the words "component" and "module," as used herein and in the following claims, is intended to encompass implementations using one or more lines of software code, and/or hardware implementations, and/or equipment for receiving manual inputs.

## Claims

1. A method for frame error concealment in encoded audio data using extension coding where lower frequency content is mapped to higher frequencies, comprising:

   receiving (204) encoded audio data in a plurality of frames; and
   reconstructing (206), (208) at least one parameter for a frame with frame error based on at least one saved parameter value from at least one other frame of the plurality of frames,
   wherein reconstructing at least one parameter comprises:
   deriving modified discrete cosine transform spectrum values, m, for a higher frequency range in accordance with *for*

$$k = 0; k < L_{highspectrum}; k++$$
$$m\left(k + L_{lowspectrum}\right) = m_{prev}\left(k\right) * fac_{spect},$$

   wherein $m_{prev}$ denotes at least one saved higher layer modified discrete cosine transform spectrum value, $L_{highspectrum}$ denotes the number of modified discrete cosine transform spectrum values over the higher spectrum, $L_{lowspectrum}$ denotes the number of modified discrete cosine transform spectrum values over the low spectrum and $fac_{spect}$ denotes respective scaling factor;
   deriving values for a subset of the modified discrete cosine transform spectrum values for the higher frequency range in accordance with *for*

$$k = 0; k < N_{\sin}; k++$$
$$m\left(pos_{\sin}\left(k\right) + L_{lowspectrum}\right) = m_{prev}\left(pos_{\sin}\left(k\right)\right) * fac_{\sin}$$

   wherein $m_{prev}$ denotes said at least one saved higher layer modified discrete cosine transform spectrum, $fac_{sin}$ denotes respective scaling factor and $pos_{sin}$ is a variable descriptive of the positions within $m$ and $m_{prev}$, wherein if a preceding valid frame to the frame with frame error is a generic frame, the $fac_{spect}$ scaling factor is smaller than the $fac_{sin}$ scaling factor, wherein if the preceding valid frame to the frame with frame error is a tonal frame the $fac_{sin}$ scaling factor is only used and wherein the variable descriptive of the positions within $m$, $pos_{sin}$, are from the preceding valid frame; and
   applying the derived values to the frame with frame error.

2. A method according to claim 1, wherein the at least one saved parameter value comprise at least one of:

   at least one parameter value of at least one previous frame without errors;
   at least one parameter value of the most recent previous frame without error;
   at least one parameter value of at least one previous reconstructed frame with error; and
   at least one parameter value of at least one future frame.

3. An apparatus for frame error concealment in encoded audio data using extension coding where lower frequency content is mapped to higher frequencies, comprising:

a decoder (160) configured to:

receive encoded audio data in a plurality of frames; and
reconstruct at least one parameter for a frame with frame error based on at least one saved parameter value from at least one other frame of the plurality of frames,
wherein reconstructing at least one parameter comprises:
deriving modified discrete cosine transform spectrum values, m, for a higher frequency range in accordance with *for*

$$k = 0; k < L_{highspectrum}; k++$$
$$m(k + L_{lowspectrum}) = m_{prev}(k) * fac_{spect}$$

wherein $m_{prev}$ denotes at least one saved higher layer modified discrete cosine transform spectrum value, $L_{highspectrum}$ denotes the number of modified discrete cosine transform spectrum values over the higher spectrum, $L_{lowspectrum}$ denotes the number of modified discrete cosine transform spectrum values over the low spectrum and $fac_{spect}$ denotes respective scaling factor;
deriving values for a subset of the modified discrete cosine transform spectrum values for the higher frequency range in accordance with *for*

$$k = 0; k < N_{sin}; k++$$
$$m(pos_{sin}(k) + L_{lowspectrum}) = m_{prev}(pos_{sin}(k)) * fac_{sin}$$

wherein $m_{prev}$ denotes said at least one saved higher layer modified discrete cosine transform spectrum, $fac_{sin}$ denotes respective scaling factor and $pos_{sin}$ is a variable descriptive of the positions within $m$ and $m_{prev}$ wherein if a preceding valid frame to the frame with frame error is a generic frame, the $fac_{spect}$ scaling factor is smaller than the $fac_{sin}$ scaling factor, wherein if the preceding valid frame to the frame with frame error is a tonal frame the $fac_{sin}$ scaling factor is only used and wherein the variable descriptive of the positions within $m$, $pos_{sin}$, are from the preceding valid frame; and
applying the derived values to the frame with frame error.

4. An apparatus according to claim 3, wherein the at least one saved parameter value comprise at least one of
at least one parameter value of at least one previous frame without errors,
at least one parameter value of the most recent previous frame without error,
at least one parameter value of at least one previous reconstructed frame with error, and at least one parameter value of at least one future frame.

5. A computer program product for frame error concealment in encoded audio data using extension coding where lower frequency content is mapped to higher frequencies, comprising a computer-readable medium bearing computer program code embodied therein for use with a computer, the computer program code comprising:

code causing the apparatus to receive encoded audio data in a plurality of frames; and
code for reconstructing at least one parameter for a frame with frame error based on at least one saved parameter value from at least one other frame of the plurality of frames,
wherein the code for reconstructing at least one parameter comprises:
code for deriving modified discrete cosine transform spectrum values, m, for a higher frequency range in accordance with *for*

$$k = 0; k < L_{highspectrum}; k++$$
$$m(k + L_{lowspectrum}) = m_{prev}(k) * fac_{spect}$$

wherein $m_{prev}$ denotes at least one saved higher layer modified discrete cosine transform spectrum value, $L_{highspectrum}$ denotes the number of modified discrete cosine transform spectrum values over the higher spectrum, $L_{lowspectrum}$ denotes the number of modified discrete cosine transform spectrum values over the low spectrum and $fac_{spect}$ denotes respective scaling factor;

code for deriving values for a subset of the modified discrete cosine transform spectrum values for the higher frequency range in accordance with *for*

$$k = 0; k < N_{\sin}; k++$$
$$m\left(pos_{\sin}(k) + L_{lowspectrum}\right) = m_{prev}\left(pos_{\sin}(k)\right) * fac_{\sin}$$

wherein $m_{prev}$ denotes said at least one saved higher layer modified discrete cosine transform spectrum, $fac_{\sin}$ denotes respective scaling factor and $pos_{\sin}$ is a variable descriptive of the positions within $m$ and $m_{prev}$ wherein if a preceding valid frame to the frame with frame error is a generic frame, the $fac_{spect}$ scaling factor is smaller than the $fac_{\sin}$ scaling factor, wherein if the preceding valid frame to the frame with frame error is a tonal frame the $fac_{\sin}$ scaling factor is only used and wherein the variable descriptive of the positions within $m, pos_{\sin}$, are from the preceding valid frame; and

code for applying the derived values to the frame with frame error.

**Patentansprüche**

1. Verfahren für eine Rahmenfehlerverschleierung bei codierten Audiodaten unter Verwendung von Erweiterungscodierung, wobei Inhalt niedrigerer Frequenz höheren Frequenzen zugeordnet wird, umfassend:

Empfangen (204) codierter Audiodaten in mehreren Rahmen; und
Rekonstruieren (206), (208) mindestens eines Parameters für einen Rahmen mit Rahmenfehler basierend auf mindestens einem gespeicherten Parameterwert von mindestens einem anderen Rahmen der mehreren Rahmen,
wobei das Rekonstruieren mindestens eines Parameters umfasst:
Ableiten von Spektralwerten einer modifizierten diskreten Kosinustransformation, m, für einen höheren Frequenzbereich gemäß *für*

$$k = 0; k < L_{highspectrum}; k++$$
$$m\left(k + L_{lowspectrum}\right) = m_{prev}(k) * fak_{spect},$$

wobei $m_{prev}$ mindestens einen gespeicherten Spektralwert einer modifizierten diskreten Kosinustransformation einer höheren Schicht bezeichnet, $L_{highspectrum}$ die Anzahl von Spektralwerten einer modifizierten diskreten Kosinustransformation im höheren Spektrum bezeichnet, $L_{lowspectrum}$ die Anzahl von Spektralwerten einer modifizierten diskreten Kosinustransformation im niedrigen Spektrum bezeichnet und $fak_{spect}$ einen jeweiligen Skalierungsfaktor bezeichnet;
Ableiten von Werten für einen Teilsatz der Spektralwerte einer modifizierten diskreten Kosinustransformation für den höheren Frequenzbereich gemäß *für*

$$k = 0; k < N_{sin}; k++$$
$$m\left(pos_{sin}(k) + L_{lowspectrum}\right) = m_{prev}\left(pos_{sin}(k)\right) * fak_{sin}$$

wobei *mprev* mindestens ein gespeichertes Spektrum einer modifizierten diskreten Kosinustransformation einer höheren Schicht bezeichnet, $fak_{sin}$ einen jeweiligen Skalierungsfaktor bezeichnet und $pos_{sin}$ eine Variable ist, die die Positionen in m und $m_{prev}$ beschreibt, wobei, wenn ein dem Rahmen mit Rahmenfehler vorhergehender gültiger Rahmen ein allgemeiner Rahmen ist, der Skalierungsfaktor $fak_{spect}$ kleiner als der Skalierungsfaktor $fak_{sin}$ ist, wobei, wenn der dem Rahmen mit Rahmenfehler vorhergehende gültige Rahmen ein tonaler Rahmen ist, nur der Skalierungsfaktor $fak_{sin}$ verwendet wird, und wobei die Variable, die die Positionen in m beschreibt, $pos_{sin}$, von dem vorhergehenden gültigen Rahmen sind; und
Anwenden der abgeleiteten Werte auf den Rahmen mit Rahmenfehler.

2. Verfahren nach Anspruch 1, wobei der mindestens eine gespeicherte Parameterwert mindestens eines von Folgendem umfasst:

mindestens einen Parameterwert von mindestens einem vorherigen Rahmen ohne Fehler;
mindestens einen Parameterwert von dem aktuellsten vorherigen Rahmen ohne Fehler;
mindestens einen Parameterwert von mindestens einem vorherigen rekonstruierten Rahmen ohne Fehler; und
mindestens einen Parameterwert von mindestens einem zukünftigen Rahmen.

3. Einrichtung für eine Rahmenfehlerverschleierung bei codierten Audiodaten unter Verwendung von Erweiterungscodierung, wobei Inhalt niedrigerer Frequenz höheren Frequenzen zugeordnet wird, umfassend:
eine Dekodiervorrichtung (160), die zu Folgendem ausgestaltet ist:

Empfangen codierter Audiodaten in mehreren Rahmen; und
Rekonstruieren mindestens eines Parameters für einen Rahmen mit Rahmenfehler basierend auf mindestens einem gespeicherten Parameterwert von mindestens einem anderen Rahmen der mehreren Rahmen,
wobei das Rekonstruieren mindestens eines Parameters umfasst:
Ableiten von Spektralwerten einer modifizierten diskreten Kosinustransformation, m, für einen höheren Frequenzbereich gemäß *für*

$$k = 0; k < L_{highspectrum}; k++$$
$$m(k + L_{lowspectrum}) = m_{prev}(k) * fak_{spect},$$

wobei $m_{vorher}$ mindestens einen gespeicherten Spektralwert einer modifizierten diskreten Kosinustransformation einer höheren Schicht bezeichnet, $L_{highspectrum}$ die Anzahl von Spektralwerten einer modifizierten diskreten Kosinustransformation im höheren Spektrum bezeichnet, $L_{lowspectrum}$ die Anzahl von Spektralwerten einer modifizierten diskreten Kosinustransformation im niedrigen Spektrum bezeichnet und $fak_{spect}$ einen jeweiligen Skalierungsfaktor bezeichnet;
Ableiten von Werten für einen Teilsatz der Spektralwerte einer modifizierten diskreten Kosinustransformation für den höheren Frequenzbereich gemäß *für*

$$k = 0; k < N_{sin}; k++$$
$$m(pos_{sin}(k) + L_{lowspectrum}) = m_{prev}(pos_{sin}(k)) * fak_{sin},$$

wobei $m_{prev}$ mindestens ein gespeichertes Spektrum einer modifizierten diskreten Kosinustransformation einer höheren Schicht bezeichnet, $fak_{sin}$ einen jeweiligen Skalierungsfaktor bezeichnet und $pos_{sin}$ eine Variable ist, die die Positionen in $m$ und $m_{prev}$ beschreibt, wobei, wenn ein dem Rahmen mit Rahmenfehler vorhergehender gültiger Rahmen ein allgemeiner Rahmen ist, der Skalierungsfaktor $fak_{spect}$ kleiner als der Skalierungsfaktor $fak_{sin}$ ist, wobei, wenn der dem Rahmen mit Rahmenfehler vorhergehende gültige Rahmen ein tonaler Rahmen ist, nur der Skalierungsfaktor $fak_{sin}$ verwendet wird, und wobei die Variable, die die Positionen in m beschreibt, $pos_{sin}$, von dem vorhergehenden gültigen Rahmen sind; und
Anwenden der abgeleiteten Werte auf den Rahmen mit Rahmenfehler.

4. Einrichtung nach Anspruch 3, wobei der mindestens eine gespeicherte Parameterwert mindestens eines von Folgendem umfasst:

mindestens einen Parameterwert von mindestens einem vorherigen Rahmen ohne Fehler,
mindestens einen Parameterwert von dem aktuellsten vorherigen Rahmen ohne Fehler,
mindestens einen Parameterwert von mindestens einem vorherigen rekonstruierten Rahmen ohne Fehler, und
mindestens einen Parameterwert von mindestens einem zukünftigen Rahmen.

5. Computerprogrammprodukt für eine Rahmenfehlerverschleierung bei codierten Audiodaten unter Verwendung von Erweiterungscodierung, wobei Inhalt niedrigerer Frequenz höheren Frequenzen zugeordnet wird, umfassend ein computerlesbares Medium, auf dem ein Computerprogrammcode für eine Verwendung mit einem Computer enthalten ist, wobei der Computerprogrammcode umfasst:

Code, der die Einrichtung veranlasst, codierte Audiodaten in mehreren Rahmen zu empfangen; und

Code zum Rekonstruieren mindestens eines Parameters für einen Rahmen mit Rahmenfehler basierend auf mindestens einem gespeicherten Parameterwert von mindestens einem anderen Rahmen der mehreren Rahmen,

wobei der Code zum Rekonstruieren mindestens eines Parameters umfasst:

Code zum Ableiten von Spektralwerten einer modifizierten diskreten Kosinustransformation, m, für einen höheren Frequenzbereich gemäß *für*

$$k = 0; k < L_{highspectrum}; k + +$$
$$m(k + L_{lowspectrum}) = m_{prev}(k) * fak_{spect},$$

wobei $m_{vorher}$ mindestens einen gespeicherten Spektralwert einer modifizierten diskreten Kosinustransformation einer höheren Schicht bezeichnet, $L_{hohesSpektrum}$ die Anzahl von Spektralwerten einer modifizierten diskreten Kosinustransformation im höheren Spektrum bezeichnet, $L_{lowspectrum}$ die Anzahl von Spektralwerten einer modifizierten diskreten Kosinustransformation im niedrigen Spektrum bezeichnet und $fak_{spect}$ einen jeweiligen Skalierungsfaktor bezeichnet;

Code zum Ableiten von Werten für einen Teilsatz der Spektralwerte einer modifizierten diskreten Kosinustransformation für den höheren Frequenzbereich gemäß *für*

$$k = 0; k < N_{sin}; k + +$$
$$m(pos_{sin}(k) + L_{lowspectrum}) = m_{prev}(pos_{sin}(k)) * fak_{sin}$$

wobei $m_{prev}$ mindestens ein gespeichertes Spektrum einer modifizierten diskreten Kosinustransformation einer höheren Schicht bezeichnet, $fak_{sin}$ einen jeweiligen Skalierungsfaktor bezeichnet und $pos_{sin}$ eine Variable ist, die die Positionen in m und $m_{prev}$ beschreibt, wobei, wenn ein dem Rahmen mit Rahmenfehler vorhergehender gültiger Rahmen ein allgemeiner Rahmen ist, der Skalierungsfaktor $fak_{spect}$ kleiner als der Skalierungsfaktor $fak_{sin}$ ist, wobei, wenn der dem Rahmen mit Rahmenfehler vorhergehende gültige Rahmen ein tonaler Rahmen ist, nur der Skalierungsfaktor $fak_{sin}$ verwendet wird, und wobei die Variable, die die Positionen in $m$ beschreibt, $pos_{sin}$, von dem vorhergehenden gültigen Rahmen sind; und

Code zum Anwenden der abgeleiteten Werte auf den Rahmen mit Rahmenfehler.

**Revendications**

1. Procédé de masquage d'erreurs sur trames dans des données audio codées à l'aide d'un codage d'extension où un contenu plus basses fréquences est transposé en fréquences plus élevées, comprenant :

la réception (204) de données audio codées dans une pluralité de trames ; et
la reconstruction (206), (208) d'au moins un paramètre pour une trame à erreur sur trame sur la base d' au moins une valeur de paramètre sauvegardée issue d'au moins une autre trame de la pluralité de trames,
la reconstruction d'au moins un paramètre comprenant :
l'obtention de valeurs, m, de spectre de transformée en cosinus discrets modifiée pour une plage de fréquences plus élevées conformément à *pour*

$$k=0 \; ; \; k<L_{highspectrum} \; ; \; k++$$
$$m(k+L_{lowspectrum})=m_{prev}(k) * fac_{spect},$$

$m_{prev}$ désignant au moins une valeur de spectre de transformée en cosinus discrets modifiée de couche supérieure sauvegardée, $L_{highspectrum}$ désignant le nombre de valeurs de spectre de transformée en cosinus discrets modifiée sur le spectre supérieur, $L_{lowspectrum}$ désignant le nombre de valeurs de spectre de transformée en cosinus discrets modifiée sur le spectre inférieur et $fac_{spect}$ désignant un facteur d'échelle respectif ;
l'obtention de valeurs pour un sous-ensemble des valeurs de spectre de transformée en cosinus discrets modifiée pour la plage de fréquences plus élevées conformément à *pour*

$$k=0 \; ; \; k<N_{sin} \; ; \; k++$$
$$m(pos_{sin}(k)+L_{lowspectrum})=m_{prev}(pos_{sin}(k))*fac_{sin},$$

$m_{prev}$ désignant ledit au moins un spectre de transformée en cosinus discrets modifiée de couche supérieure sauvegardé, $fac_{sin}$ désignant un facteur d'échelle respectif et $pos_{sin}$ représentant une variable décrivant les positions dans $m$ et $m_{prev}$ ; si une trame valide précédente de la trame à erreur sur trame est une trame générique, le facteur d'échelle $fac_{spect}$ étant inférieur au facteur d'échelle $fac_{sin}$; si la trame valide précédente de la trame à erreur sur trame est une trame tonale, seul le facteur d'échelle $fac_{sin}$ étant utilisé ; et la variable décrivant les positions dans $m$, $pos_{sin}$, étant issue de la trame valide précédente ; et l'application des valeurs obtenues à la trame à erreur sur trame.

2. Procédé selon la revendication 1, dans lequel l'au moins une valeur de paramètre sauvegardée comprend
au moins une valeur de paramètre d'au moins une trame précédente sans erreur ; et/ou
au moins une valeur de paramètre de la trame précédente sans erreur la plus récente ; et/ou
au moins une valeur de paramètre d'au moins une trame reconstruite précédente avec erreur ; et/ou
au moins une valeur de paramètre d'au moins une trame future.

3. Appareil de masquage d'erreurs sur trames dans des données audio codées à l'aide d'un codage d'extension où un contenu plus basses fréquences est transposé en fréquences plus élevées, comprenant :
un décodeur (160) configuré pour :

recevoir des données audio codées dans une pluralité de trames ; et
reconstruire au moins un paramètre pour une trame à erreur sur trame sur la base d'au moins une valeur de paramètre sauvegardée issue d'au moins une autre trame de la pluralité de trames,
la reconstruction d'au moins un paramètre comprenant :
l'obtention de valeurs, m, de spectre de transformée en cosinus discrets modifiée pour une plage de fréquences plus élevées conformément à *pour*

$$k=0 \; ; \; k<L_{highspectrum} \; ; \; k++$$
$$m(k+L_{lowspectrum})=m_{prev}(k)*fac_{spect},$$

$m_{prev}$ désignant au moins une valeur de spectre de transformée en cosinus discrets modifiée de couche supérieure sauvegardée, $L_{highspectrum}$ désignant le nombre de valeurs de spectre de transformée en cosinus discrets modifiée sur le spectre supérieur, $L_{lowspectrum}$ désignant le nombre de valeurs de spectre de transformée en cosinus discrets modifiée sur le spectre inférieur et $fac_{spect}$ désignant un facteur d'échelle respectif ;
l'obtention de valeurs pour un sous-ensemble des valeurs de spectre de transformée en cosinus discrets modifiée pour la plage de fréquences plus élevées conformément à *pour*

$$k=0 \; ; \; k<N_{sin} \; ; \; k++$$
$$m(pos_{sin}(k)+L_{lowspectrum})=m_{prev}(pos_{sin}(k))*fac_{sin},$$

$m_{prev}$ désignant ledit au moins un spectre de transformée en cosinus discrets modifiée de couche supérieure sauvegardé, $fac_{sin}$ désignant un facteur d'échelle respectif et $pos_{sin}$ représentant une variable décrivant les positions dans $m$ et $m_{prev}$ ; si une trame valide précédente de la trame à erreur sur trame est une trame générique, le facteur d'échelle $fac_{spect}$ étant inférieur au facteur d'échelle $fac_{sin}$; si la trame valide précédente de la trame à erreur sur trame est une trame tonale, seul le facteur d'échelle $fac_{sin}$ étant utilisé ; et la variable décrivant les positions dans $m$, $pos_{sin}$, étant issue de la trame valide précédente ; et l'application des valeurs obtenues à la trame à erreur sur trame.

4. Appareil selon la revendication 3, dans lequel l'au moins une valeur de paramètre sauvegardée comprend
au moins une valeur de paramètre d'au moins une trame précédente sans erreur, et/ou
au moins une valeur de paramètre de la trame précédente sans erreur la plus récente, et/ou
au moins une valeur de paramètre d'au moins une trame reconstruite précédente avec erreur, et/ou
au moins une valeur de paramètre d'au moins une trame future.

**5.** Produit-programme d'ordinateur pour le masquage d'erreurs sur trames dans des données audio codées à l'aide d'un codage d'extension où un contenu plus basses fréquences est transposé en fréquences plus élevées, comprenant un support lisible par ordinateur incorporant un code de programme d'ordinateur destiné à être utilisé conjointement avec un ordinateur, le code de programme d'ordinateur comprenant :

un code pour amener l'appareil à recevoir des données audio codées dans une pluralité de trames ; et
un code pour reconstruire au moins un paramètre pour une trame à erreur sur trame sur la base d'au moins une valeur de paramètre sauvegardée issue d'au moins une autre trame de la pluralité de trames,
le code pour reconstruire au moins un paramètre comprenant :
un code pour obtenir des valeurs, m, de spectre de transformée en cosinus discrets modifiée pour une plage de fréquences plus élevées conformément à *pour*

$$k=0 \ ; \ k<L_{highspectrum} \ ; \ k++$$
$$m(k+L_{lowspectrum})=m_{prev}(k)*fac_{spect},$$

$m_{prev}$ désignant au moins une valeur de spectre de transformée en cosinus discrets modifiée de couche supérieure sauvegardée, $L_{highspectrum}$ désignant le nombre de valeurs de spectre de transformée en cosinus discrets modifiée sur le spectre supérieur, $L_{lowspectrum}$ désignant le nombre de valeurs de spectre de transformée en cosinus discrets modifiée sur le spectre inférieur et $fac_{spect}$ désignant un facteur d'échelle respectif ;
un code pour obtenir des valeurs pour un sous-ensemble des valeurs de spectre de transformée en cosinus discrets modifiée pour la plage de fréquences plus élevées conformément à *pour*

$$k=0 \ ; \ k<N_{sin} \ ; \ k++$$
$$m(pos_{sin}(k)+L_{lowspectrum})=m_{prev}(pos_{sin}(k))*fac_{sin},$$

$m_{prev}$ désignant ledit au moins un spectre de transformée en cosinus discrets modifiée de couche supérieure sauvegardé, $fac_{sin}$ désignant un facteur d'échelle respectif et $pos_{sin}$ représentant une variable décrivant les positions dans $m$ et $m_{prev}$ ; si une trame valide précédente de la trame à erreur sur trame est une trame générique, le facteur d'échelle $fac_{spect}$ étant inférieur au facteur d'échelle $fac_{sin}$ ; si la trame valide précédente de la trame à erreur sur trame est une trame tonale, seul le facteur d'échelle $fac_{sin}$ étant utilisé ; et la variable décrivant les positions dans $m$, $pos_{sin}$, étant issue de la trame valide précédente ; et
un code pour appliquer les valeurs obtenues à la trame à erreur sur trame.

Figure 1

Figure 2A

Figure 2B

Figure 3A

Figure 3B

signal A

signal B

"good frame"

reconstructed "bad frame"

210

220

212

214

222

224

230

240

Figure 4

Figure 5

Figure 6

```
┌─────────────┐
│   Source    │
│    100      │
└─────────────┘
       │
       ▼
┌─────────────┐
│   Encoder   │
│    110      │
└─────────────┘
       │
       ▼
┌─────────────┐
│   Storage   │
│    120      │
└─────────────┘
       │
       ▼
┌─────────────┐
│   Sender    │
│    130      │
└─────────────┘
       │
       ▼
┌─────────────┐
│   Gateway   │
│    140      │
└─────────────┘
       │
       ▼
┌─────────────┐
│   Receiver  │
│    150      │
└─────────────┘
       │
       ▼
┌─────────────┐
│   Decoder   │
│    160      │
└─────────────┘
       │
       ▼
┌─────────────┐
│   Renderer  │
│    170      │
└─────────────┘
```

Figure 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004059894 A
- WO 2008062959 A